# EUROPEAN PATENT APPLICATION

(11) **EP 4 376 063 A1**
(43) Date of publication of application: **29.05.2024**
(21) Application number: 23200981.1
(22) Date of filing: 29.09.2023
(51) Int. Cl.: H01L 21/768, H01L 23/528

(54) **INTEGRATED CIRCUIT INTERCONNECT LEVEL COMPRISING MULTI-HEIGHT LINES AND SELF-ALIGNED VIAS**

(30) Priority: 22.11.2022 US 202217992818
(71) Applicant: INTEL Corporation, Santa Clara, CA 95054 (US)
(72) Inventor: KARPOV, Elijah, Portland, 97229 (US); CHOI, June, Portland, 97229 (US); CHANDHOK, Manish, Beaverton, 97006 (US); RESHOTKO, Miriam, Portland, 97221 (US); METZ, Matthew, Portland, 97229 (US)
(74) Representative: HGF

(57) **Abstract**

Integrated circuitry comprising an interconnect level with multi-height lines contacted by complementary multi-height vias. In some examples, a first line of a taller height is contacted by a first via of a shorter height while a second line of a shorter height is contacted by a second via of a taller height. The first and second vias and first and second lines may be subtractively defined concurrently from a same stack of conductive material layers such that the first via comprises a first conductive material layer, and the first line comprises second and third conductive material layers while the second via comprises the first and second conductive material layers and the second line comprises the third conductive material layer.

## Description

### BACKGROUND

Demand for higher performance integrated circuits (ICs) in electronic device applications has motivated increasingly dense transistor architectures. IC metallization structures employed to interconnect transistors into circuitry need to scale to higher density in step with increasing transistor density. For decades, IC metallization has relied upon an "etch and fill" paradigm whereby openings are formed in a dielectric material are backfilled with a metallization. However, metallization features scale down as interconnect density increases and as the aspect ratio of metallization lines and vias between different levels of interconnect lines parasitic electrical resistance increases. Large energy delay products attributable to line-to-line capacitance can also lead to higher power consumption and degraded performance.

Accordingly, advanced IC interconnect architectures have been developed to overcome limitations associated with filling topographic features of increasingly greater aspect ratio with conductive material. U.S. Patent 11,239,156, for example, describes an interconnect structure including subtractively patterned lines and subtractively patterned planar slab vias. As described, planar slab via fabrication may be integrated into subtractive line pattering that is practiced to form underlying interconnect lines. U.S. Patent 11,444,024 further describes subtractively defined interconnect structures utilizing multiple cap materials to pattern such slab vias.

Interconnect lines of multiple heights (e.g., taller and shorter) within a single interconnect line level offer the potential to independently tune interconnect line resistance and capacitance. Accordingly, structures integrating vias with such multi-height interconnect lines, and techniques for fabricating such structures, may prove commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 illustrates a flow diagram of methods for forming an interconnect level comprising multi-height vias in contact with multi-height lines, in accordance with some embodiments;
FIG. 2 illustrates a cross-sectional view of stack of conductive material layers, in accordance with some embodiments;
FIG. 3 illustrates a cross-sectional view of multi-height vias contacting complementary multi-height lines, in accordance with some embodiments;
FIG. 4 illustrates a flow diagram of methods for forming multi-height vias self-aligned to lines of complementary height, in accordance with some embodiments;
FIG. 5A, 5B, 5C, 5D, 5E, 5F, 5G and 5H are isometric illustrations depicting formation of precursor lines from a conductive material layer stack, in accordance with some embodiments;
FIG. 6A, 6B, 6C, 6D, 6E, 6F, 6G and 6H are isometric illustrations depicting a patterning of precursor lines into shorter metal lines contacted by taller vias and taller metal lines contacted by shorter vias, in accordance with some embodiments;
FIG. 7A and 7B are isometric drawings illustrating an interconnect level comprising multi-height vias contacting multi-height lines, in accordance with some embodiments;
FIG. 8 is a cross-sectional view of a double-sided 3D IC structure, in accordance with some embodiments;
FIG. 9 illustrates a mobile computing platform and a data server machine employing an IC device including at least one interconnect level with multi-height vias centered upon multi-height lines, in accordance with some embodiments; and
FIG. 10 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a chemical composition that is predominantly a first constituent means more than half of the chemical composition is the first constituent (e.g., <50 at. %). The term "primarily" means the most, or greatest, part. For example, a composition that is primarily a first constituent means the chemical composition has more of the first constituent than any other constituent. A chemical composition that is primarily first and second constituents means the composition has more of the first and second constituents than any other constituent. The term "substantially" means there is only incidental variation. For example, a composition that is substantially a first constituent means the composition may further include <1% of any other constituent. A composition that is substantially first and second constituents means the composition may further include <1 % of any constituent substituted for either the first or second constituent.

In accordance with some embodiments herein, monolithic integrated circuitry includes a device layer electrically coupled through one or more interconnect levels and least one of the interconnect levels comprises multi-height vias in contact with lines of a height complementary to that of corresponding vias in contact with the lines. The interconnect level with multi-height vias in contact with lines of a height complementary to that of corresponding vias may be on either a frontside or backside of a device layer. The interconnect level may convey power or I/O signals or to/from the device layer, depending on the implementation.

Within a thickness of the interconnect level, a line of a greater height is contacted by a via of a lesser height. Within that same thickness, another line of a lesser height is contacted by a via of a greater height. The first and second vias and first and second lines may be subtractively defined concurrently from a same stack of conductive material layers such that the vias are self-aligned to be exactly centered over a transverse width of the underlying lines. A via of lesser height may be patterned from a first conductive material layer of the stack while the underlying line may be patterned from multiple (e.g., second and third) conductive material layers of the stack. A via of greater height may be patterned from multiple (e.g., the first and second) conductive material layers while the underlying line may be patterned from the third conductive material layer.

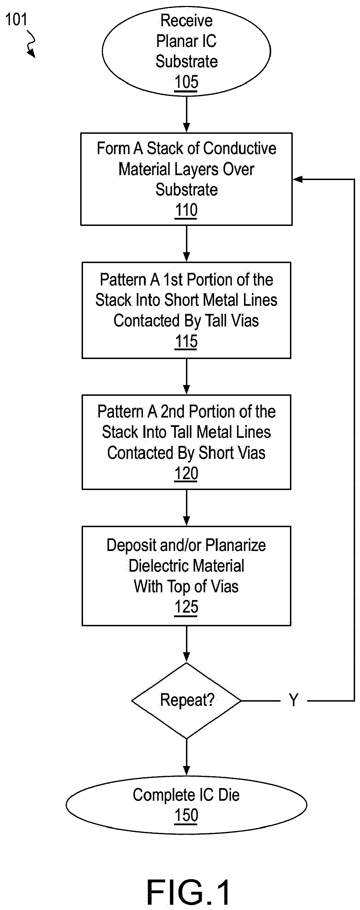

FIG. 1 illustrates a flow diagram of methods 101 for forming an interconnect level comprising multi-height vias in contact with multi-height lines, in accordance with some embodiments. Methods 101 begin with receiving an IC substrate at input 105. A top material surface of the IC substrate received is advantageously substantially planar having no topographic features of any significant aspect ratio requiring a material fill. In some exemplary embodiments, the planarized surface includes both dielectric material and a top surface of conductive contacts that are coupled to terminals of devices within an underlying device level of the IC substrate. The device level may comprise transistors, other semiconductor devices (e.g., diodes, memory devices), magnetic memory devices, ferroelectric memory devices, or the like.

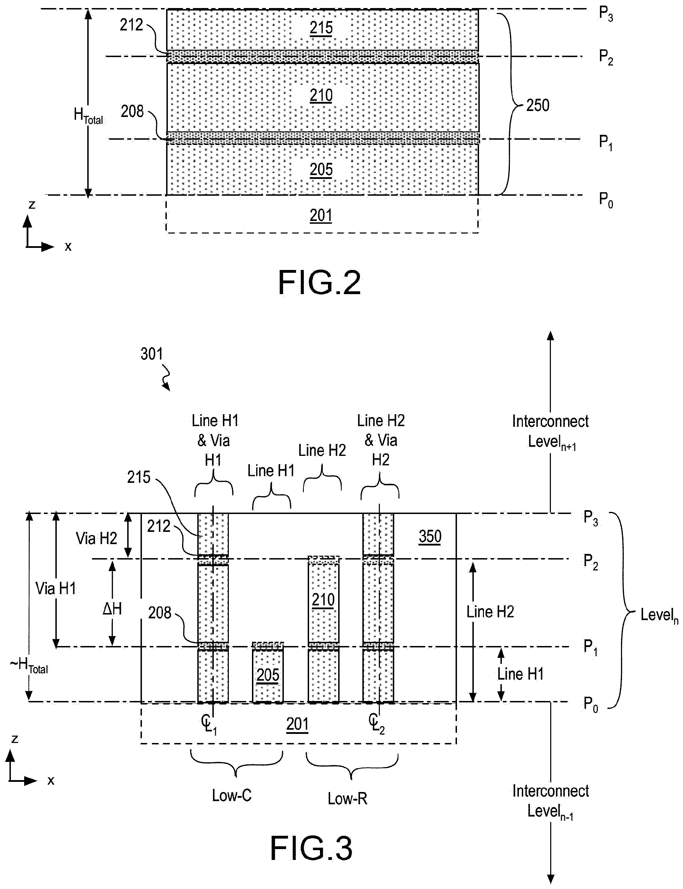

At block 110, a stack of conductive material layers is formed over the IC substrate. FIG. 2 illustrates a cross-sectional view of an electrically conductive material layer stack 250 on a planar surface of substrate 201, in accordance with some exemplary embodiments. The planar surface may be a frontside or backside of substrate 201. Substrate 201 may include a substantially (mono)crystalline material. Substrate 201 may, for example, include one or more Group IV semiconductor material layers (e.g., Si, Ge, SiGe, GeSn, etc.), one or more Group III-V semiconductor material layers (e.g., InGaAs), one or more Group III-N semiconductor material layers (e.g., GaN), a combination of such semiconductor material layers, or other material (e.g., sapphire) known to be suitable as a workpiece substrate for IC device fabrication.

Substrate 201 may further include one or more device layers, each including one or more semiconductor material layers. Substrate 201 may also have one or more interconnect levels comprising metallization features that electrically interconnect devices (e.g., transistors, DRAM memory cells, RRAM memory cells, MRAM memory cells, etc.) of the device layer(s) and/or supply power to such devices. In some examples, substrate 201 includes MOSFETs (not depicted) in a region of a monocrystalline semiconductor device layer (e.g., silicon, Ge, SiGe, GeSn, etc.). Such FETs may be part of any application specific IC (ASIC) including one or more IP cores, for example. In some embodiments, structures within substrate 201 comprise a microprocessor core, further including an arithmetic logic unit (ALU) and shift registers, for example. In other examples, structures within substrate 201 comprise a wireless radio circuit or floating-point gate array (FPGA).

Substrate 201 may further comprise metallization features, such as one or more electrically conductive vias (not depicted). Substrate 201 may further include one or more dielectric material layers (not depicted) surrounding metallization features interconnecting devices with substrate 201. The chemical composition of the dielectric material may be any known to be suitable as an IC device interlayer dielectric (ILD). In some embodiments, the dielectric material comprises oxygen and may further comprise silicon (e.g., SiO₂, SiOC(H), SiON, etc.).

Both lines and vias of an interconnect level are to be formed from an electrically conductive material stack 250. Stack 250 has a vertical height (e.g., along z-axis) Hₜₒₜₐₗ that may include any number of layers as dependent on the number of different heights of lines and vias to be patterned from the stack. In exemplary embodiments, stack 250 includes at least three electrically conductive material layers 205, 210 and 215. For exemplary embodiments where the surface of substrate 201 is substantially planar (e.g., coincident with an x-y plane P₀), interfaces of each of the layers in conductive material stack 250 are coincident with planes (e.g., P₁-P₃) that are substantially parallel with the substrate surface plane P₀. In view of this planarity, the various layers of stack 250 may be referred to as material "slabs."

In some embodiments, electrically conductive material slabs or layers 205, 210 and 215 are all in direct contact, for example with conductive material layer 210 on conductive material layer 205, and conductive material layer 215 on conductive material layer 210. For such embodiments, conductive material layer 210 has a different composition than conductive material layers 205 and 215. Although compositions may vary, the compositions are to have good (i.e., high) electrical conductivity and be amenable to subtractive patterning by one or more etch processes with differences in their compositions to provide a basis for etch selectively. Conductive material layers 205, 210 and 215 may comprise predominantly one or more metals, for example. In some exemplary embodiments, conductive material layer 205 is a first of primarily Ru, primarily Mo, or primarily W while conductive material layers 210 and 215 are each a second of primarily Ru, primarily Mo, or primarily W. Conductive material layer 210 may have the same composition as conductive material layer 215, or not.

In alternative embodiments, at least two of conductive material layers 205, 210 and 215 are spaced apart by an intervening electrically conductive material layer. In the illustrated example, intervening material layer 208 is on material layer 205 and material layer 210 is on intervening material layer 208. Intervening electrically conductive material layer 212 is on material layer 210 and material layer 215 is on intervening material layer 212. As described further below, intervening material layers 208 and 212 may serve as etch stop layers, in which case material layers 205, 210 and 215 may all have the same composition, but need not.

The composition of each electrically conductive material layer (including intervening layers 208 and 212) advantageously has good electrical conductivity as they are retained within at least the interconnect vias fabricated in accordance with embodiments herein. Each conductive material layer should also be amenable to subtractive patterning by one or more etch processes with differences in their compositions to provide a basis for etch selectively. In some exemplary embodiments, intervening material layers 208 and 212 are each any of Ti or Ta (or nitride thereof), or a first of Ru, Mo, or W, while material layers 205, 210 and 215 are of one or more compositions that are different than the composition(s) of material layers 208 and 212. For example, material layers 205, 210 and 215 may be any of Ru, Mo, or W in implementations where intervening material layers 208 and 212 are Ti or Ta. In another example where intervening material layers 208 and 212 are a first of Ru, Mo, or W, material layers 205, 210 and 215 may each be a second of Ru, Mo, or W. In some examples, material layer 208 has the same composition as material layer 212 (e.g., W), but these layers may also be of different compositions. Material layers 205, 210 and 215 may all have the same chemical composition (e.g., Ru), but these material layers may also be of different compositions.

Slab thicknesses (e.g., z-axis) of each material layer 205-215 may vary with implementation. Intervening material layers 208 and 212 may be significantly thinner than material layers 205, 210 or 215. In some exemplary embodiments, the thickness of intervening material layers 208 and 212 is less than half the thickness of at least a thickest one of material layers 205, 210 or 215. In some further embodiments, the thickness of intervening material layers 208 and 212 is less than half the thickness of all of material layers 205, 210 or 215.

Returning to FIG. 1, methods 101 continue at block 115 where a first portion or region of the electrically conductive material stack is patterned into vias of a first height (e.g., taller) in contact with lines of a complementary first height (e.g., shorter). At block 120, a second portion or region of the same conductive material stack is patterned into vias of a second height (e.g., shorter) in contact with lines of a complementary second height (e.g., taller). Any number of such portions may be patterned to achieve any number of line heights and corresponding via heights from a precursor stack. For clarity of discussion, methods 101 illustrate only two instances of patterning a material layer stack. However, a material layer stack may be similarly patterned into vias of first, second, third, fourth, etc. heights with each of such vias contacting corresponding lines of first, second, third, fourth, etc. heights.

After patterning lines and vias of various heights, methods 101 continue at block 125 where a dielectric material is deposited over and between the lines and vias. Alternatively, block 125 may be skipped, for example where an air gap technology is practiced leaving voids between various ones of the lines and/or vias formed at blocks 115 and 120. With one level of interconnect metallization complete, methods 101 may optionally iterate through blocks 110-125 any number of additional times to fabricate any number of additional levels of interconnect metallization. Methods 101 end at output 150 where IC die fabrication is completed according to any known techniques. For example, one or more additional levels of interconnect metallization may be fabricated (e.g., according to conventional damascene techniques) over the planar slab interconnect level(s) fabricated in blocks 110-125.

Within a planar slab interconnect level, each line of a particular height is contacted by a via of complementary height, meaning shorter lines are contacted by taller vias and taller lines are contacted by shorter vias. FIG. 3 illustrates a cross-sectional view of IC structure 301 including multi-height vias that contact complementary multi-height lines patterned from conductive material stack 250 (FIG. 2). FIG. 3 illustrates a cross-section passing through transverse widths of lines that have longitudinal lengths extending into/out of the page. A dielectric material 350 surrounds the conductive interconnect structures. Dielectric material 350 may have any composition known to be suitable for electrical isolation of interconnect structures, such as silicon dioxide or a low-k dielectric material.

Interconnect vias and lines patterned from conductive material layers 205-215 may be referred to as "slab" vias and "slab" lines. The illustrated slab vias and lines are within a single, n^{th} "slab" interconnect level, which may be a lowest (first) interconnect level coupling together IC devices into circuitry or may be a level between any two other (e.g., n-1 and n+1) interconnect levels. If present, interconnect levelₙ₋₁ and interconnect levelₙ₊₁ may each be another slab interconnect level, or not.

A bottom interface of the n^{th} interconnect level at plane P₀ is coincident with a bottom of interconnect lines, regardless of their height. A top interface of the n^{th} interconnect level at plane P₃ is coincident with a top of interconnect vias, regardless of their height. All lines of the n^{th} interconnect level comprise conductive material layer 205 and all vias of the n^{th} interconnect level comprise conductive material layer 215. However, conductive material layer 210 may be either a portion of a via or a portion of a line. For example, a via of height H1 comprises both conductive material layer 215 and conductive material 210. A via of height H2 comprises conductive material layer 215, but does not comprise conductive material layer 210. In a complementary fashion, a via of height H1 contacts a line of height H1 that comprises conductive material layer 205, but does not comprise conductive material layer 210. Similarly, a via of height H2 contacts a line of height H2 that comprises both conductive material layer 205 and conductive material layer 210. Hence, conductive material not included in a line is included within any via that contacts such a line so that differences in height of the lines and vias are both ΔH associated with a thickness of conductive material layer 210.

As further shown, a top of shorter lines of height H1 are coincident with plane P1 while a bottom of shorter vias of height H2 are coincident with plane P2. Conversely, a top of taller lines of height H2 are coincident with plane P2 while a bottom of taller vias of height H1 are coincident with plane P1. A centerline of each via is coincident with a longitudinal centerline of the underlying line, regardless of their respective heights. As further described below, this exact lateral (e.g., x-dimension) alignment is a result of at least portion of a perimeter of the multi-height vias and multi-height lines being patterned from a same (e.g., single) mask.

FIG. 3 further illustrates how intervening electrically conductive material layers (e.g., 208, 212) are retained within a line-via connection. For example, if intervening material layer 208 is included within an electrically conductive material stack (e.g., as an etch stop layer), material layer 208 remains at the interface of a via of height H1 and an underlying line of height H1. In the illustrated example, material layer 208 is retained over lengths of lines of height H1 even where no via lands. Alternatively, material layer 208 may be substantially absent from such line lengths (e.g., where material layer 208 is consumed during patterning). Similarly, if intervening material layer 212 is included within an electrically conductive material stack (e.g., as another etch stop layer), material layer 212 remains at the interface of a via of height H2 and an underlying line of height H2. In the example illustrated, conductive material layer 212 is retained over lengths of lines of height H2 even where no via lands. Alternatively, conductive material layer 212 may be substantially absent from such line lengths (e.g., where the layer is consumed during patterning).

In some exemplary embodiments, some device terminals of an integrated circuit are coupled to other circuit nodes by lines and vias of height H1 while other device terminals are coupled to other circuit nodes by lines and vias of height H2. As shown, lines and vias of height H1 display lower interconnect capacitance and therefore may be particularly advantageous in logic circuitry of an IC die. Lines and vias of height H2 display lower interconnect resistance and therefore may be particularly advantageous in analog and/or SRAM circuitry of the same IC die. Hence, different functional blocks of an IC die may be interconnected through interconnect lines of different line and via heights according to embodiments herein.

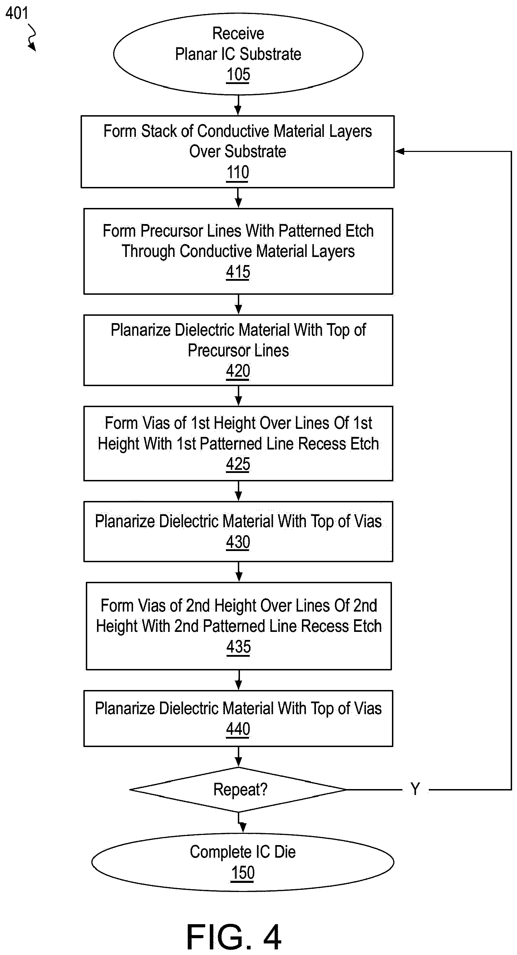

FIG. 4 illustrates a flow diagram of methods 401 for forming multi-height vias self-aligned to lines of complementary height, in accordance with some embodiments of methods 101. Methods 401 further illustrate some advantageous implementations of operations 110-125 introduced in the context of FIG. 1. For the sake of clarity, methods 401 illustrate fabrication of dual-height lines and dual-height vias, but the same principles may be readily applied to implement tri-height lines and vias, or any arbitrary number of different line and via heights.

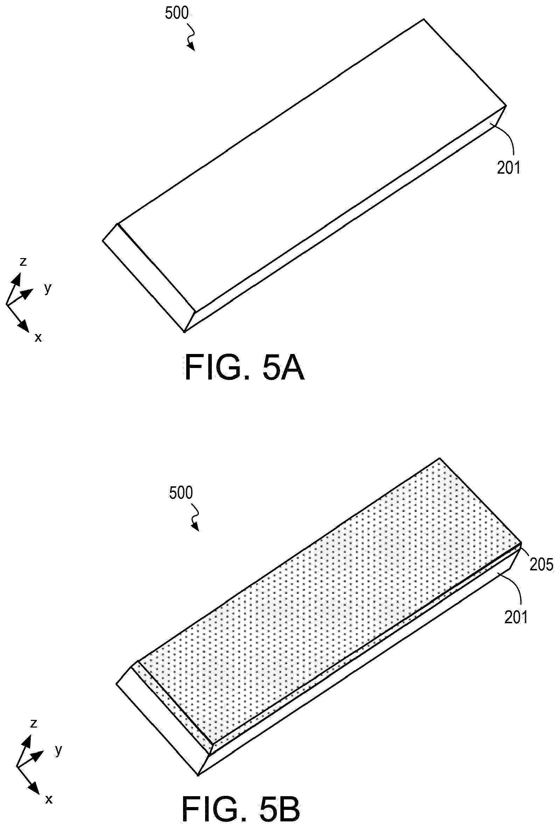

Methods 401 again begin at input 105 where an IC substrate with a substantially planar surface is received. At block 110, a stack of planar conductive material layers or slabs are formed over a backside or frontside surface of the substrate. Any blanket deposition process(es) suitable for the composition(s) may be practiced at block 110. FIG. 5A-5F further illustrate isometric views of an IC structure 500 evolving as electrically conductive material layers are successively deposited. FIG. 5A illustrates a planar substrate 201, which may have any of the features described elsewhere herein, for example. As shown in FIG. 5B, electrically conductive material layer 205 is deposited upon a surface of substrate 201, for example with a physical vapor deposition (PVD) process, chemical vapor deposition (CVD) process, or any other deposition process known to be suitable for the composition material layer 205.

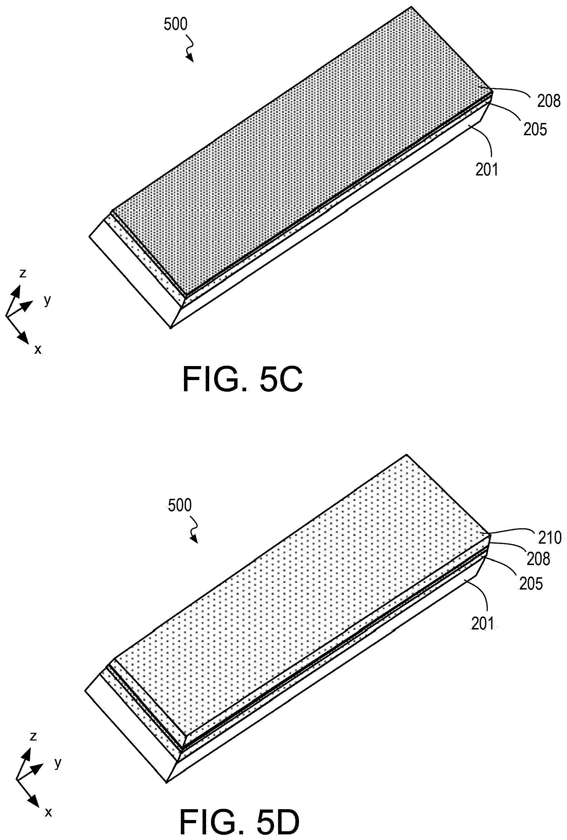

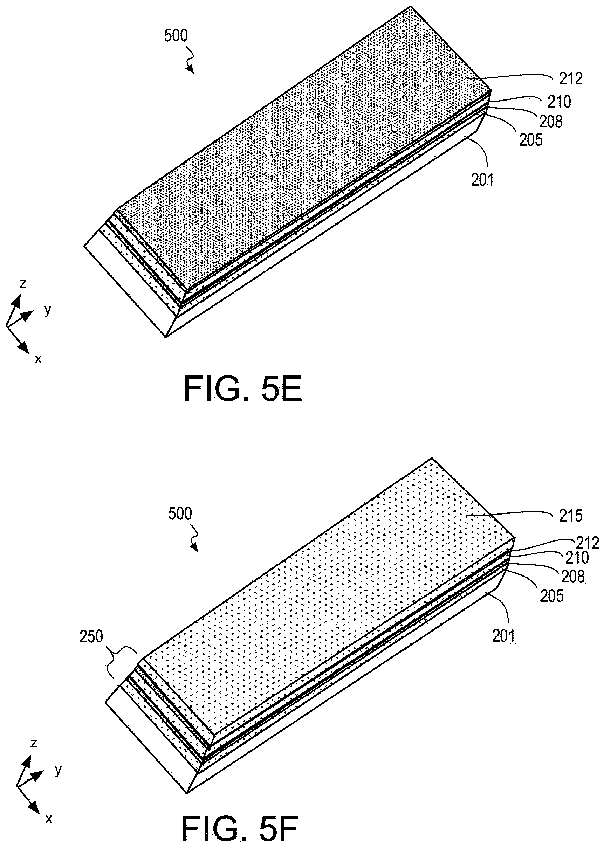

FIG. 5C illustrates a next electrically conductive material layer 208 deposited upon a surface of material layer 205, for example with a PVD, CVD, or any other deposition process known to be suitable for the composition of material layer 208. FIG. 5C illustrates a next electrically conductive material layer 208 deposited upon a surface of material layer 205, for example with a PVD, CVD, or any other deposition process known to be suitable for the composition of material layer 208. In FIG. 5D, a next electrically conductive material layer 210 has been deposited upon a surface of material layer 208, for example with a PVD, CVD, or any other deposition process known to be suitable for the composition of material layer 210. FIG. 5E illustrates a next electrically conductive material layer 212 deposited upon a surface of material layer 210, for example with a PVD, CVD, or any other deposition process known to be suitable for the composition of material layer 212. FIG. 5F illustrates an uppermost electrically conductive material layer 215 deposited upon a surface of material layer 210, for example with a PVD, CVD, or any other deposition process known to be suitable for the composition of material layer 215.

With electrically conductive material stack 250 complete, methods 401 (FIG. 4) continue at block 415 where precursor lines are formed with a patterned etch through the material layers of the stack. Any masking process may be performed at block 415 as embodiments are not limited in this respect. For example, any photoresist lithography and/or hardmasking techniques may be practiced to form a mask suitable for the etch process(es) performed at block 415. Single patterning or double patterning lithography may be employed with any exposure wavelength as embodiments are not limited in this respect.

In exemplary embodiments, the precursor lines formed at block 415 comprise the full stack of material layers. A height of the precursor lines are therefore all equal to the precursor stack height. Any etch processes known to be suitable for the various compositions of the material layers within the stack may be practiced.

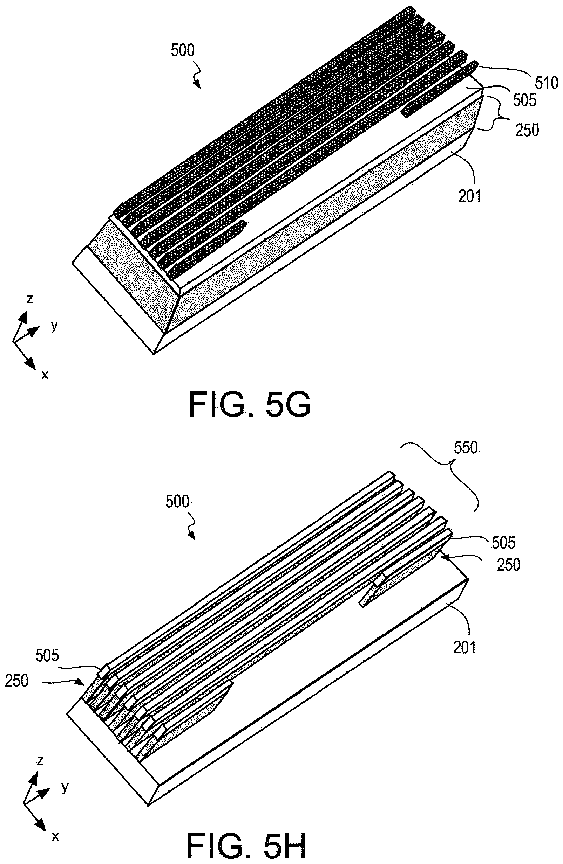

In the example further illustrated in FIG. 5G, a blanket hard mask cap material layer 505 is over conductive material layer 250 and mask features 510 are over cap material layer 505. As shown, mask features 510 are lines with their longitudinal lengths parallel to the y-axis and transverse widths parallel to the x-axis with an x-y plane being coincident with surface plane of substrate 201. For clarity, individual layers of material layer stack 250 are not depicted. For embodiments that include cap material layer 505, the cap material may be sacrificial or retained within an IC die. Cap material layer 505 may have any composition with some examples being a dielectric such as one including silicon and at least one of oxygen or nitrogen (e.g., SiO, SiN, SiON, SiOCH, SiOCN, etc.). Mask feature 510 may comprise any photoresist (e.g., EUV) or any alternative mask material of different composition than cap material layer 505.

FIG. 5H illustrates precursor lines 550 that have been defined by etching through cap material 505 and through electrically conductive material layer stack 250 to expose substrate 201 within spaces between precursor lines 550. In FIG. 5H, mask features 510 are no longer present, having been either consumed during the precursor line etch or subsequently stripped.

Returning to FIG. 4, methods 401 continue at block 420 where one or more dielectric materials are deposited and planarized with the precursor lines. At block 420, any dielectric material known to be suitable for electrical isolation of IC interconnect structures, such as silicon dioxide or a low-k material, may be deposited. In some exemplary embodiments, a low-k dielectric material with a relative permittivity below 3.5 is deposited at block 420. The low-k dielectric material may have any composition suitable for integrated circuitry.

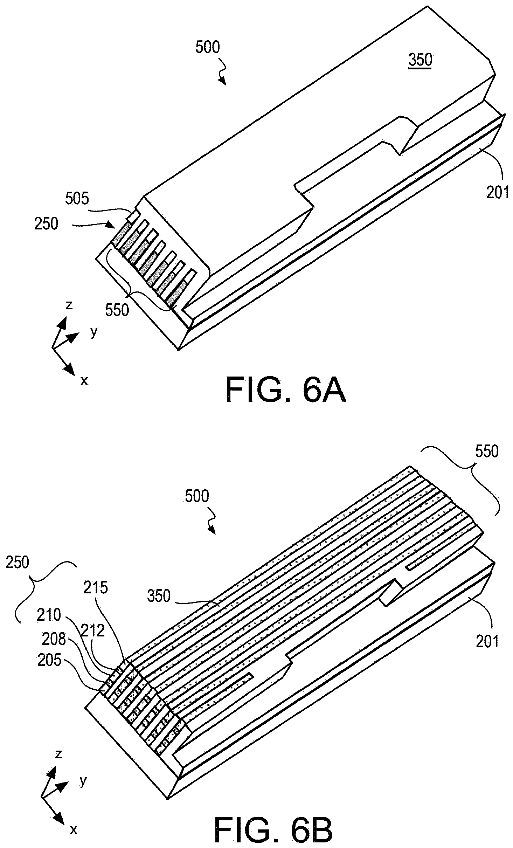

In the example further illustrated in FIG. 6A, IC structure 500 has evolved to include dielectric material 350 over precursor lines 550. In the depicted embodiment, dielectric material 350 is also at least partially filling spaces between precursor lines 550. There may also be airgaps (not depicted) between adjacent precursor lines 550. FIG. 6B further illustrates IC structure 500 following planarization of dielectric material 350 with a surface of conductive material stack 250. In this example, cap material 505 has been removed during planarization so that a surface of electrically conductive material layer 215 is substantially coplanar with a surface of surrounding dielectric material 350.

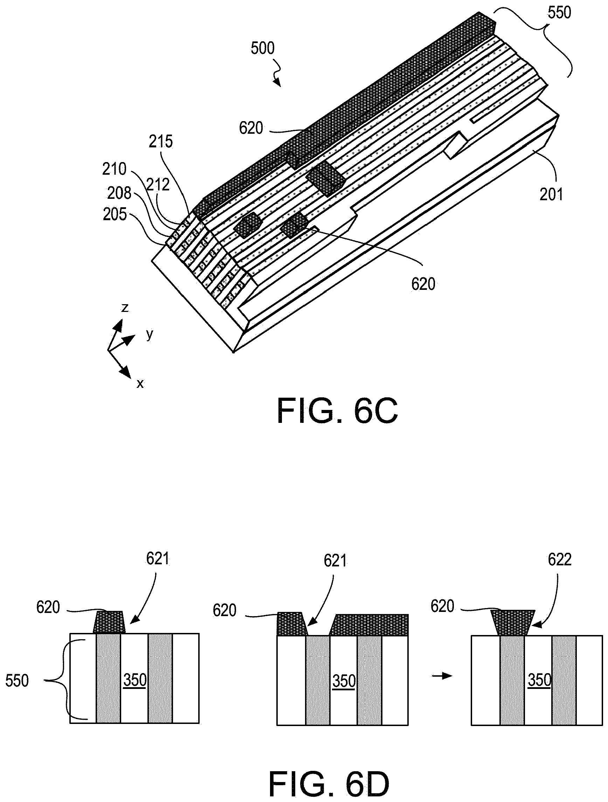

Returning to FIG. 4, methods 401 continue at block 425 where vias of a first height are formed over lines of a first height with a first patterned recess etch of the precursor lines. Any masking process may be performed at block 425 as embodiments are not limited in this respect. For example, any photoresist lithography and/or hardmasking techniques may be practiced to form a mask suitable for the etch process(es) performed at block 425. Single patterning or double patterning lithography may be employed with any exposure wavelength. In the example illustrated in FIG. 6C, mask features 620 protect portions of the precursor lines that are not to be recessed to a first height. In some embodiments where the first recess etch defines lines of a shorter height, mask features 620 protect segments of the precursor lines that are to be vias of taller height contacting the shorter lines. Mask features 620 also protect segments of the precursor lines that are to become interconnect line lengths of taller height or are to become vias of shorter height, as further described below.

Via masking may amount to only a small pillar mask and since small openings can often be printed with better resolution than small pillars, the mask features illustrated in FIG. 6C may undergo a mask inversion process, for example with any commercially available sacrificial light absorbing material (SLAM). Hence, mask features 620 may not be photoresist, but rather a non-photosensitive material that has been derived from a photosensitive pattern of opposite polarity. For example, as further illustrated in FIG. 6D, directly patterned mask features 620, whether pillars or holes, may have some characteristic positive sidewall slope 621. Another material deposited over the directly patterned mask features to arrive at mask features of opposite polarity may then have a characteristic negative sidewall slope 622.

Any etch processes known to be suitable for the various compositions of the conductive materials within the stack that are to be etched during the first precursor line recess etch may be practiced at block 425. In exemplary embodiments, at least one of the etch processes practiced is selective to the composition of one of the conductive material layers within the stack so that the recess etch is well-controlled to a particular depth defined by the planar conductive material layer deposition sequence. For exemplary embodiments where the first recess etch defines lines of shorter height, the etch process(es) extend through material layers 215 and 210, as well as intervening material layer 212 (if present).

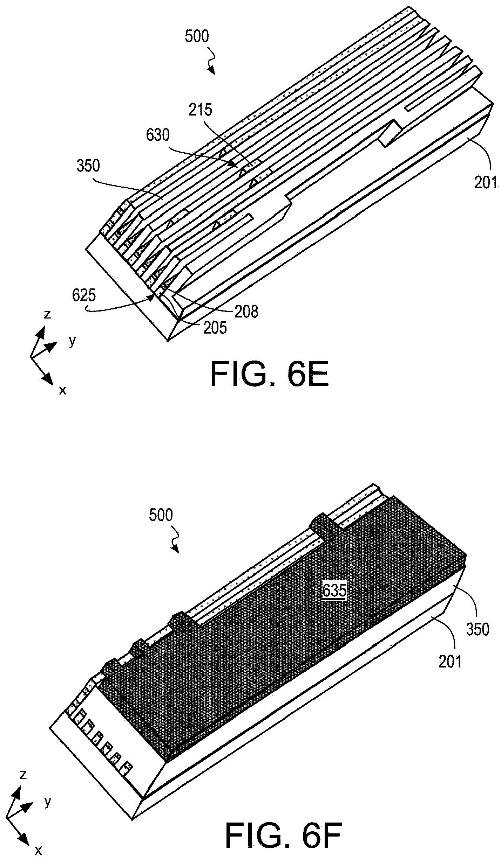

Advantageously, at least a last portion of etch process(es) practiced at block 425 is selective to either material layer 205 or intervening layer 208 (if present) so that line height is well controlled. FIG. 6E illustrates exemplary IC structure 500 following a first recess etch that defines interconnect lines 625 of a shorter height. In this example, the recess etch stops on intervening material layer 208. However, once exposed, intervening material layer 208 may be removed or retained as part of (shorter) interconnect lines 625. With mask features removed, (taller) vias 630 are visible as comprising conductive material 215. With vias 630 and lines 625 having been defined from the same precursor line previously defined from a single mask, a centerline of vias 630 (e.g., within the z-x plane) are exactly aligned with a centerline of the underlying lines 625. Vias 630 are therefore referred to herein as "self-aligned" to lines 625.

Returning to FIG. 4, methods 401 continue at block 430 where dielectric material is deposited and the vias defined at block 425 are planarized with the dielectric material. Any dielectric material may be deposited at block 430 with one example being the same dielectric material deposited at block 420. Methods 401 then continue at block 435 where vias of another (second) height are formed over lines of another (second) height with a second patterned recess etch of the precursor lines. Notably, the lines of a second height may be either shorter or taller than the lines of a first height fabricated at block 425. In other words, the order of blocks 425 and 435 within methods 401 is flexible and can, for example, be swapped.

Any masking process may be performed at block 435 as embodiments are not limited in this respect. For example, any photoresist lithography and/or hardmasking techniques may be practiced to form a mask suitable for the etch process(es) performed at block 435. Single patterning or double patterning lithography may be employed with any exposure wavelength. In the example illustrated in FIG. 6F, mask features 635 protect regions where the precursor lines are not to be recessed to a second height. Mask features 635 may further protect regions of dielectric material 350. In some embodiments where the second recess etch defines lines of a taller height, mask features 635 protect segments of the precursor lines that are to become vias of shorter height.

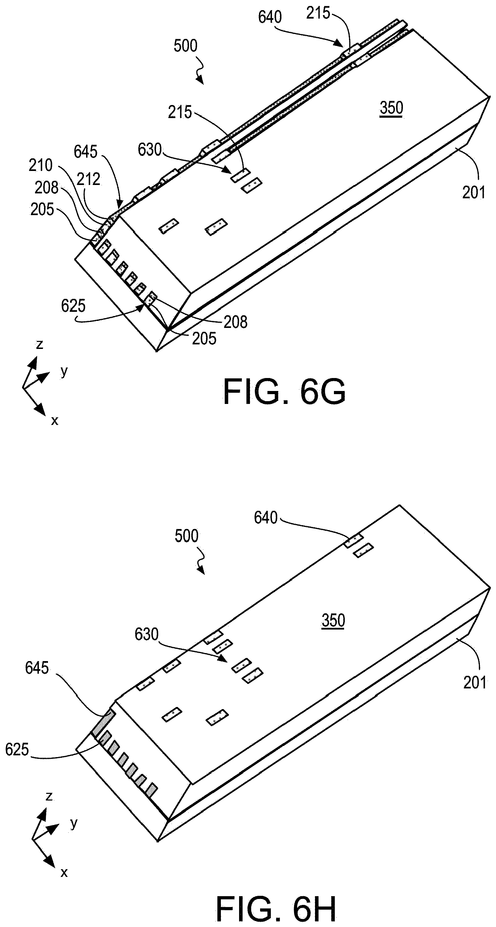

FIG. 6G illustrates IC structure 500 following a second recess etch that defines lines of a greater height that stops on intervening layer 212. However, once exposed, intervening layer 212 may be removed or retained as part of (taller) interconnect lines 645. The second recess etch removes conductive material layer 215 except where it is retained as (shorter) vias 640. With vias 640 and (taller) lines 645 having been defined from the same precursor line previously defined from a single mask, a centerline of vias 640 (e.g., within the z-x plane) are exactly aligned with a centerline of the underlying lines 645. Vias 640 are therefore referred to herein as "self-aligned" to lines 645 in substantially the same manner vias 630 are self-aligned to lines 625.

Returning to FIG. 4, methods 401 continue at block 440 where dielectric material is deposited and planarized with the vias of the interconnect level. Any dielectric material may be deposited at block 440 with one example being the same dielectric material deposited at blocks 420 and/or 430. Methods 401 may then iterate through blocks 110-440 any number of times to form another interconnect level in substantially the same manner. IC die fabrication is then completed at output 150 according to any known techniques.

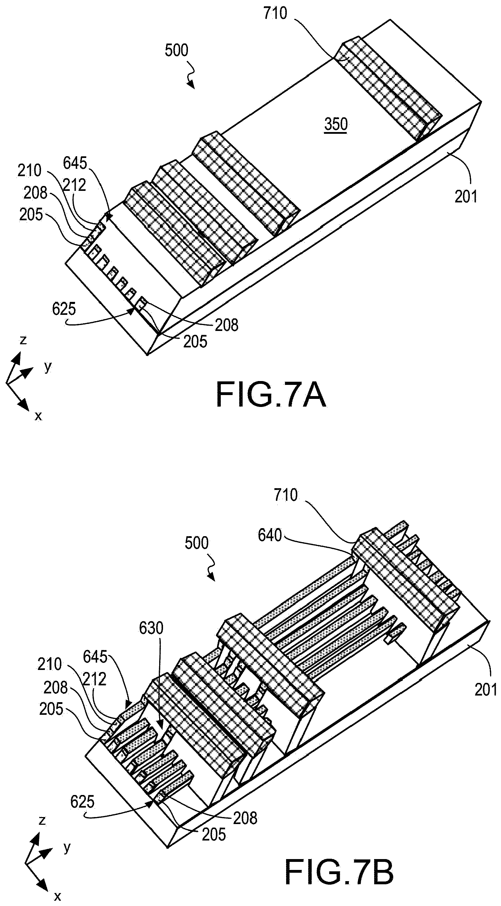

FIG. 6H illustrates IC structure 500 with top surfaces of both vias 630 and 640 substantially planar with dielectric material 350. Interconnect lines 625 and 645 are buried below the planar surface of dielectric material 350. FIG. 7A further illustrates IC structure 500 following fabrication of an overlying interconnect level comprising interconnect lines 710. In this example, all interconnect lines 710 are again substantially parallel, but have longitudinal lengths orthogonal to those of the underlying interconnect level. Interconnect lines 710 comprise a conductive material and contact short and tall vias 630 and 640.

In FIG. 7B, a portion of dielectric material 350 has been removed to further illustrate interconnection of lines 710 to lines 625, 645 of different height through vias 630, 640 of complementary heights. The depicted etchback of dielectric material 350 need not be practiced in the fabrication of an IC die and is instead presented merely for the sake of illustration.

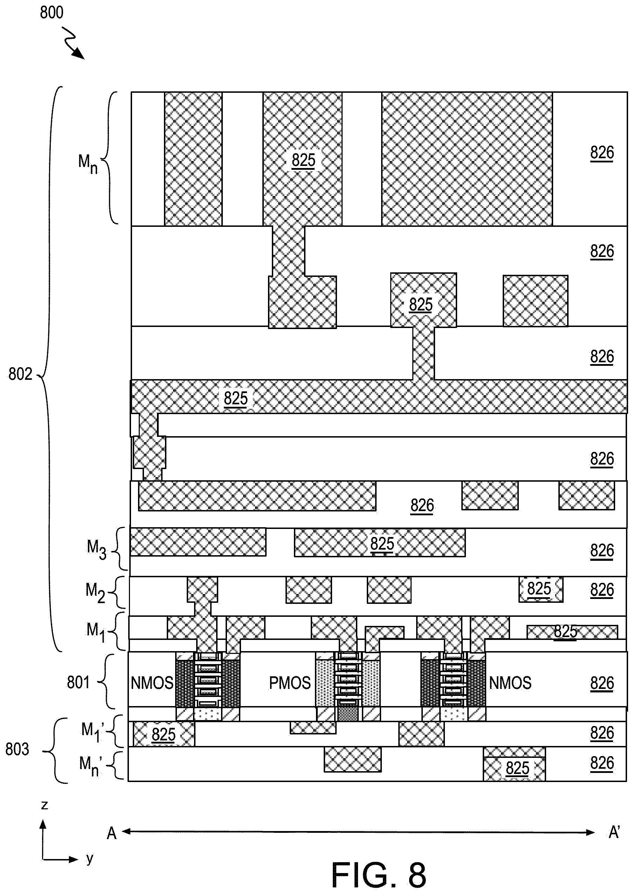

The planar slab interconnect structures and methods of manufacture described above may be integrated into a wide variety of ICs and computing systems that include such ICs. FIG. 8 is a cross-sectional view of a double-sided IC structure 800, in accordance with some embodiments. Double-sided IC structure 801 illustrates a portion of a monolithic IC that includes FEOL interconnect metallization levels 802 over and/or on a front side of transistor structures 801 that include ribbon or wire (RoW) transistor structures, for example.

Within double-sided IC structure 800, front-side interconnect metallization levels 801 include interconnect metallization 825 electrically insulated by dielectric material 826. In the exemplary embodiment illustrated, front-side interconnect metallization levels 180 includes metal-one (M₁), metal-two (M₂), metal-three (M₃) and metal-n (Mₙ) interconnect metallization levels. Interconnect metallization 825 may be any metal(s) suitable for IC interconnection. Interconnect metallization 825, may be, for example, an alloy of predominantly Cu, an alloy of predominantly W, an alloy of predominantly Ru, an alloy of predominantly Al, an alloy of predominantly Mo, etc. Dielectric material 826 may be any dielectric material known to be suitable for electrical isolation of monolithic ICs. In some embodiments, dielectric material 826 comprises silicon, and at least one of oxygen and nitrogen. Dielectric material 86 may be SiO, SiN, or SiON, for example. Dielectric material 826 may also be a low-K dielectric material (e.g., having a dielectric constant below that of SiO₂). Although metal-one is illustrated to have lines and vias of different heights, for example in accordance with some embodiments described above, any of the other metallization levels may have lines and vias of different heights.

Double-sided IC structure 800 further includes back-side interconnect metallization levels 802. Within interconnect metallization levels 802, interconnect metallization 825 is again electrically insulated by dielectric material 826. Back-side metallization levels 802 may comprise any number of metallization levels over, or on, a back side of transistor structures 801. In the illustrated example back-side metallization, metallization levels 802 include a metallization level M₁' through nearest to transistor structures 801 (e.g., opposite M₁) through a uppermost back-side metallization level Mₙ'. Although one back-side level is illustrated to have lines and vias of different heights, for example in accordance with some embodiments described above, any of the other backside metallization levels may have lines and vias of different heights.

Although IC structure 800 includes one level of transistor structures 801, there may be multiple levels of transistor structures located within the various interconnect metallization levels, for example where a front-side metallization level of one IC structure has been bonded to a back-side metallization level of another IC structure to arrive at a composite 3DIC.

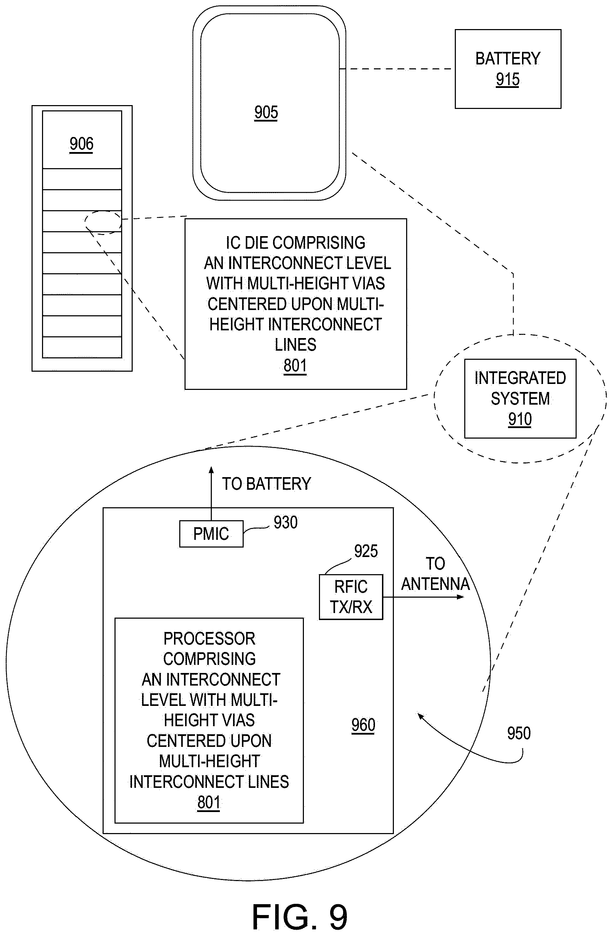

FIG. 9 illustrates a mobile computing platform 905 and a data server machine 906 employing a packaged IC die including an interconnect level with multi-height vias centered upon multi-height interconnect lines, for example as described elsewhere herein. Server machine 906 may be any commercial server, for example including any number of high-performance computing platforms disposed within a rack and networked together for electronic data processing, which in the exemplary embodiment includes packaged IC die 801 comprising an interconnect level with multi-height vias centered upon multi-height interconnect lines, for example as described elsewhere herein.

The mobile computing platform 905 may be any portable device configured for each of electronic data display, electronic data processing, wireless electronic data transmission, or the like. For example, the mobile computing platform 905 may be any of a tablet, a smart phone, laptop computer, etc., and may include a display screen (e.g., a capacitive, inductive, resistive, or optical touchscreen), an integrated system 910, and a battery 915.

As illustrated in the expanded view 950, packaged IC device 801 is further coupled to host component 960. One or more of a power management integrated circuit (PMIC) 930 or RF (wireless) integrated circuit (RFIC) 925 including a wideband RF (wireless) transmitter and/or receiver may be further coupled to host component 960. PMIC 930 may perform battery power regulation, DC-to-DC conversion, etc., and so has an input coupled to battery 915 and with an output providing a current supply to other functional modules. As further illustrated, in the exemplary embodiment, RFIC 925 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, and beyond.

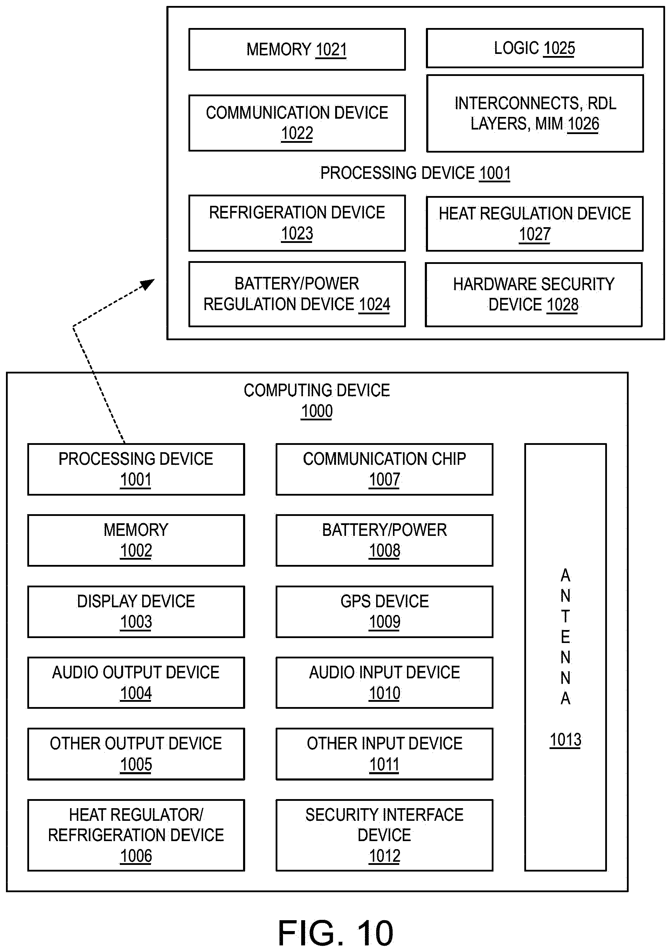

FIG. 10 is a block diagram of a cryogenically cooled computing device 1000 in accordance with some embodiments. For example, one or more components of computing device 1000 may include any of the devices or interconnect structures discussed elsewhere herein. A number of components are illustrated in FIG. 10 as included in computing device 1000, but any one or more of these components may be omitted or duplicated, as suitable for the application. In some embodiments, some or all of the components included in computing device 1000 may be attached to one or more printed circuit boards (e.g., a motherboard). In some embodiments, various ones of these components may be fabricated onto a single system-on-a-chip (SoC) die. Additionally, in various embodiments, computing device 1000 may not include one or more of the components illustrated in FIG. 10, but computing device 1000 may include interface circuitry for coupling to the one or more components. For example, computing device 1000 may not include a display device 1003, but may include display device interface circuitry (e.g., a connector and driver circuitry) to which display device 1003 may be coupled.

Computing device 1000 may include a processing device 1001 (e.g., one or more processing devices). As used herein, the term processing device or processor indicates a device that processes electronic data from registers and/or memory to transform that electronic data into other electronic data that may be stored in registers and/or memory. Processing device 1001 may include a memory 1021, a communication device 1022, a refrigeration/active cooling device 1023, a battery/power regulation device 1024, logic 1025, interconnects 1026 (i.e., optionally including redistribution layers (RDL) or metal-insulator-metal (MIM) devices), a heat regulation device 1027, and a hardware security device 1028.

Processing device 1001 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1001 may include a memory 1002, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1021 includes memory that shares a die with processing device 1001. This memory may be used as cache memory and may include embedded dynamic random-access memory (eDRAM) or spin transfer torque magnetic random-access memory (STT-M RAM).

Computing device 1000 may include a heat regulation/refrigeration device 1006. Heat regulation/refrigeration device 1006 may maintain processing device 1001 (and/or other components of computing device 1000) at a predetermined low temperature during operation. This predetermined low temperature may be any temperature discussed elsewhere herein.

In some embodiments, computing device 1000 may include a communication chip 1007 (e.g., one or more communication chips). For example, the communication chip 1007 may be configured for managing wireless communications for the transfer of data to and from computing device 1000. The term "wireless" and its derivatives may be used to describe circuits, devices, systems, methods, techniques, communications channels, etc., that may communicate data through the use of modulated electromagnetic radiation through a nonsolid medium.

Communication chip 1007 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1007 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1007 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1007 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1007 may operate in accordance with other wireless protocols in other embodiments. Computing device 1000 may include an antenna 1013 to facilitate wireless communications and/or to receive other wireless communications (such as AM or FM radio transmissions).

In some embodiments, communication chip 1007 may manage wired communications, such as electrical, optical, or any other suitable communication protocols (e.g., the Ethernet). As noted above, communication chip 1007 may include multiple communication chips. For instance, a first communication chip 1007 may be dedicated to shorter-range wireless communications such as Wi-Fi or Bluetooth, and a second communication chip 1007 may be dedicated to longer-range wireless communications such as GPS, EDGE, GPRS, CDMA, WiMAX, LTE, EV-DO, or others. In some embodiments, a first communication chip 1007 may be dedicated to wireless communications, and a second communication chip 1007 may be dedicated to wired communications.

Computing device 1000 may include battery/power circuitry 1008. Battery/power circuitry 1008 may include one or more energy storage devices (e.g., batteries or capacitors) and/or circuitry for coupling components of computing device 1000 to an energy source separate from computing device 1000 (e.g., AC line power).

Computing device 1000 may include a display device 1003 (or corresponding interface circuitry, as discussed above). Display device 1003 may include any visual indicators, such as a heads-up display, a computer monitor, a projector, a touchscreen display, a liquid crystal display (LCD), a light-emitting diode display, or a flat panel display, for example.

Computing device 1000 may include an audio output device 1004 (or corresponding interface circuitry, as discussed above). Audio output device 1004 may include any device that generates an audible indicator, such as speakers, headsets, or earbuds, for example.

Computing device 1000 may include an audio input device 1010 (or corresponding interface circuitry, as discussed above). Audio input device 1010 may include any device that generates a signal representative of a sound, such as microphones, microphone arrays, or digital instruments (e.g., instruments having a musical instrument digital interface (MIDI) output).

Computing device 1000 may include a global positioning system (GPS) device 1009 (or corresponding interface circuitry, as discussed above). GPS device 1009 may be in communication with a satellite-based system and may receive a location of computing device 1000, as known in the art.

Computing device 1000 may include another output device 1005 (or corresponding interface circuitry, as discussed above). Examples include an audio codec, a video codec, a printer, a wired or wireless transmitter for providing information to other devices, or an additional storage device.

Computing device 1000 may include another input device 1011 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1000 may include a security interface device 1012. Security interface device 1012 may include any device that provides security measures for computing device 1000 such as intrusion detection, biometric validation, security encode or decode, managing access lists, malware detection, or spyware detection. In some examples, security interface device 1012 comprises OTP ROM further including a via MIM fuse, for example as described elsewhere herein.

Computing device 1000, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments so described, but instead can be practiced with modification and alteration without departing from the scope of the appended claims. For example, the above embodiments may include specific combinations of features as further provided below.

In first examples, an integrated circuit (IC) structure comprises electrical interconnects. A level of the electrical interconnects comprises a first via in contact with a first line. The first via comprises a first electrically conductive material layer of a first height, and the first line comprises a second electrically conductive material layer of a second height. The level of electrical interconnects comprises a second via in contact with a second line. The second via comprises the first conductive material layer of the first height, and the second conductive material layer of the second height. The second line comprises a third electrically conductive material layer of a third height.

In second examples, for any of the first examples the first line further comprises the third conductive material layer of the third height.

In third examples, for any of the first or second examples a height of the first via summed with a height of the first line is substantially equal to a height of the second via summed with a height of the second line.

In fourth examples, for any of the first through third examples the first conductive material layer is in direct contact with the second conductive material layer and the second conductive material layer is in direct contact with the third conductive material layer.

In fifth examples, for any of the first through fourth examples one of the first, second and third conductive material layers has a first composition and a second of the first, second and third conductive material layers has a second composition, different than the first composition.

In sixth examples, for any of the fifth examples the first composition comprises a first of Ru, Mo, or W and wherein the second composition comprises a second or Ru, Mo, or W.

In seventh examples, for any of the first through sixth examples the first via or the first line further comprises an electrically conductive etch stop layer between the first and second conductive material layers.

In eighth examples, for any of the first through seventh examples the second via or the second line comprises an electrically conductive etch stop layer between the second and third conductive material layers.

In ninth examples, for any of the eighth examples the first via or the first line further comprises a second electrically conductive etch stop layer between the first and second conductive material layers.

In tenth examples, for any of the ninth examples the first, second and third conductive material layers have a first composition and the first and second etch stop layers have a second composition.

In eleventh examples, for any of the tenth examples the first composition comprises a first of Ru, Mo, or Wand wherein the second composition comprises Ti, Ta, or a second of Ru, Mo, or W.

In twelfth examples, for any of the first through eleventh examples a centerline of the first via is coincident with a longitudinal centerline of the first line and a centerline of the second via is coincident with a longitudinal centerline of the second line.

In thirteenth examples, for any of the first through twelfth examples planes coincident with an interface of each of the first, second and third materials layers are all substantially parallel to each other.

In fourteenth examples, an integrated circuit (IC) structure comprises a device level comprising semiconductor device structures and electrical interconnects coupling the semiconductor device structures into circuitry. A level of the electrical interconnects comprises a first via in contact with a first line. The first via comprises a first conductive material layer of a first height, and the first line comprises a second conductive material layer of a second height. The level of electrical interconnects comprises a second via in contact with a second line. The second via comprises the first conductive material layer of the first height and the second conductive material layer of the second height, and the second line comprises a third conductive material layer of a third height. The electrical interconnects comprise a second interconnect level comprises one or more third lines over, and in contact with, the first via and the second via.

In fifteenth examples, for any of the fourteenth examples the first and second lines are substantially parallel and extend in a first direction, and the one or more third lines comprise a single line extending in a direction substantially orthogonal to the first direction.

In sixteenth examples for any of the fourteenth through fifteenth examples a first intervening conductive material layer is between the first and second conductive material layers and wherein a second intervening conductive material layer is between the second and third conductive material layers.

In seventeenth examples a method of fabricating an IC structure comprises forming a stack of electrically conductive material layers over a substantially planar substrate surface, etching a first portion of the stack into a short metal line contacted by a tall via, and etching a second portion of the stack into a tall metal line contacted by short via.

In eighteenth examples, for any of the seventeenth examples forming the stack comprises depositing a first conductive material layer over the substrate, depositing a second conductive material layer over the first conductive material layer, and depositing a third conductive material layer over the second conductive material layer.

In nineteenth examples, for any of the seventeenth through eighteenth examples, forming the stack further comprises depositing a first etch stop layer over the first conductive material layer before depositing the second conductive material layer, and depositing a second etch stop layer over the second material conductive layer before depositing the third conductive layer.

In twentieth examples, for any of the seventeenth through nineteenth examples forming the short metal line contacted by a tall via comprises forming a precursor line within the first portion of the stack by etching through the stack, planarizing a dielectric material with the precursor line, and protecting a first segment of the precursor line with a mask while recess etching a second segment of the precursor line by a first amount.

In twenty-first examples, for any of the twentieth examples forming the tall metal line contacted by a short via comprises forming a second precursor line within the second portion of the stack by etching through the stack, planarizing the dielectric material with the second precursor line, and protecting a first segment of the second precursor line with a mask while recess etching a second segment of the second precursor line by a second amount, less than the first amount.

In twenty-second examples, for any of the seventeenth through twenty-first examples the method further comprises planarizing a dielectric material with a top of the tall via and with a top of the short via.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An integrated circuit (IC) structure comprising electrical interconnects, wherein a level of the electrical interconnects comprises:
a first via in contact with a first line, wherein the first via comprises a first electrically conductive material layer of a first height, and wherein the first line comprises a second electrically conductive material layer of a second height;
a second via in contact with a second line, wherein the second via comprises the first conductive material layer of the first height, and the second conductive material layer of the second height, and the second line comprises a third electrically conductive material layer of a third height.

2. The IC structure of claim 1, wherein the first line further comprises the third conductive material layer of the third height.

3. The IC structure of any one of claims 1-2, wherein a height of the first via summed with a height of the first line is substantially equal to a height of the second via summed with a height of the second line.

4. The IC structure of any one of claims 1-3, wherein the first conductive material layer is in direct contact with the second conductive material layer and the second conductive material layer is in direct contact with the third conductive material layer.

5. The IC structure of claim 4, wherein one of the first, second and third conductive material layers has a first composition and wherein a second of the first, second and third conductive material layers has a second composition, different than the first composition.

6. The IC structure of claim 5, wherein the first composition comprises a first of Ru, Mo, or W and wherein the second composition comprises a second or Ru, Mo, or W.

7. The IC structure of any one of claims 1-6, wherein the first via or the first line further comprises an electrically conductive etch stop layer between the first and second conductive material layers.

8. The IC structure of any one of claims 1-7, wherein the second via or the second line comprises an electrically conductive etch stop layer between the second and third conductive material layers.

9. The IC structure of claim 8, wherein the first via or the first line further comprises a second electrically conductive etch stop layer between the first and second conductive material layers.

10. The IC structure of claim 9, wherein the first, second and third conductive material layers have a first composition and both the first etch stop layer and the second etch stop layer have a second composition.

11. The IC structure of claim 10, wherein the first composition comprises a first of Ru, Mo, or W and wherein the second composition comprises Ti, Ta, or a second of Ru, Mo, or W.

12. The IC structure of any one of claims 1-11, wherein a centerline of the first via is coincident with a longitudinal centerline of the first line, and wherein a centerline of the second via is coincident with a longitudinal centerline of the second line.

13. The IC structure of any one of claims 1-12, further comprising a device level comprising semiconductor device structures, wherein the electrical interconnects couple the semiconductor device structures into circuitry.

14. A method of fabricating an IC structure, the method comprising:
forming a stack of electrically conductive material layers over a substantially planar substrate surface;
etching a first portion of the stack into a short metal line contacted by a tall via; and
etching a second portion of the stack into a tall metal line contacted by short via.

15. The method of claim 14, wherein forming the stack comprises:
depositing a first electrically conductive material layer over the substrate;
depositing a second electrically conductive material layer over the first layer;
depositing a third electrically conductive material layer over the second material layer;
depositing a first etch stop layer over the first material layer before depositing the second material layer; and
depositing a second etch stop layer over the second material layer before depositing the third material layer.
